# EUROPEAN PATENT APPLICATION

(11) **EP 4 571 833 A2**
(43) Date of publication of application: **18.06.2025**
(21) Application number: 24214658.7
(22) Date of filing: 21.11.2024
(51) Int. Cl.: H01L 25/065, H01L 23/538, H01L 21/50, H01L 23/053, H01L 23/055, H01L 23/552

(54) **STACKED ELECTRONIC PACKAGES**

(30) Priority: 22.11.2023 US 202318518345
(71) Applicant: NXP USA, Inc., Austin, TX 78735 (US)
(72) Inventor: KISHORE, Sharan, 5656AG Eindhoven (NL); SANTOS, Fernando A., 5656AG Eindhoven (NL); Van STRATEN, Freek Egbert, 5656AG Eindhoven (NL); LAKSHMINARAYAN, Viswanathan, 5656AG Eindhoven (NL)
(74) Representative: Hardingham, Christopher Mark

(57) **Abstract**

Electronic device packages that include a cavity which can be gas-filled, evacuated, or filled by another material can be formed by stacking multiple circuit substrates ("carriers") which are joined to together by interposers disposed between pairs of circuit substrates such that one or more cavities are formed between adjacent carriers. The interposers can include interconnections which can electrically couple devices or other structures on or within a first carrier to devices or structures on or within another carrier, including contacts formed on an exterior surface of a package.

## Description

### TECHNICAL FIELD

Embodiments of the subject matter described herein relate to packages for electronic devices that include multiple circuit boards or other substrates.

### BACKGROUND

Electronic devices such as integrated circuits are often packaged in polymer or ceramic housings which can be designed to protect the devices from damage, help dissipate heat, and to provide macroscopic contacts that allow the devices to be coupled to other devices on printed circuit boards and other substrates. In some applications, it is desirable to provide a hollow or gas-filled cavity within a package to accommodate high-frequency components.

### SUMMARY

In an example embodiment, an assembly includes a first circuit substrate having a top surface and bottom surface; a second circuit substrate having a top surface and bottom surface; and a first interposer substrate disposed between the first circuit substrate and the second circuit substrate.

The second circuit substrate is disposed above the first circuit substrate and the bottom surface of the second circuit substrate faces the top surface of the first circuit substrate. The first interposer substrate is disposed between the first circuit substrate and the second circuit substrate mechanically couples the first circuit substrate to the second circuit substrate. A first electronic component is mechanically bonded and electrically coupled to the top surface of the first circuit substrate or to the bottom surface of the second circuit substrate. The interposer first substrate, the top surface of the first circuit substrate, and the bottom surface of the second circuit substrate jointly define a cavity between the first circuit substrate and the second circuit substrate.

In another example embodiment, a method includes providing a first circuit substrate having a top surface and bottom surface; providing a second circuit substrate having a top surface and bottom surface; and coupling the first circuit substrate to the second circuit substrate by coupling a first interposer substrate between the first circuit substrate and the second circuit substrate that mechanically couples the first circuit substrate to the second circuit substrate.

The second circuit substrate is disposed above the first circuit substrate and bonding the second circuit substrate and the bottom surface of the second circuit substrate faces the top surface of the first circuit substrate. The first electronic component is mechanically bonded and electrically coupled to the top surface of the first circuit substrate or to the bottom surface of the second circuit substrate. The first interposer substrate, the top surface of the first circuit substrate, and the bottom surface of the second circuit substrate jointly define a cavity between the first circuit substrate and the second circuit substrate.

In one or more embodiments: a first set of electrical contacts is disposed on a circuit substrate that is spaced apart from the first circuit substrate; and the first set of electrical contacts includes electrical contacts that are coupled to one or more electronic components within the assembly.

In one or more embodiments, the first circuit substrate is coupled to the first interposer substrate via a metal pin that is mated with a corresponding socket; the metal pin protrudes from a surface of the first interposer substrate and the corresponding socket is a recessed socket formed in the first circuit substrate; or the metal pin protrudes from a surface of the first circuit substrate and the corresponding socket is a recessed socket formed in the first interposer substrate.

In one or more embodiments, the first electronic component is mechanically bonded and electrically coupled to the top surface of the first circuit substrate; and a second electronic component is mechanically bonded and electrically coupled to the bottom surface of the second circuit substrate.

In one or more embodiments, the cavity is filled with a volume of polymeric molding material. In one or more embodiments, an outer edge of the assembly is encapsulated within a volume of polymeric molding material.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a partially exploded cross-sectional view of a multilevel circuit assembly according to one or more embodiments
FIG. 2 is a cross-sectional view of the assembly of FIG. 1 after individual circuit carrier substrates ("carriers") have been coupled to each other via interposer substrates ("interposers").
FIG. 3 is a partially exploded cross-section of another example assembly that illustrates embodiments in which carriers are joined to each other via interposers via a system of mating pins and sockets.
FIG. 4 is a cross-sectional view of another example assembly which illustrates features of one or more embodiments.
FIG. 5 is a cross-sectional view of another example assembly which illustrates features of one or more embodiments.
FIG. 6 is a partially cross-sectional view which illustrates features of one or more embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

Unless explicitly stated otherwise, the use of terms "approximately," "substantially" and similar terms in connection with dimensions, relative positioning, or orientation of various features indicates that the dimensions, positioning, or orientation of those features are subject to tolerances and/or expected process variations of equipment and processes chosen to form the described features. Unless explicitly stated otherwise, the use of terms "approximately," "substantially" and similar terms in connection measurable values or characteristics is subject to the expected measurement accuracy of equipment and methods used to measure those values or characteristics and/or within tolerance limits specified by technical standards applicable to the technologies described.

It will be appreciated that the steps of various processes described herein are non-limiting examples of suitable processes according to embodiments and are for the purposes of illustration. Embodiments herein may use any suitable processes including those that omit steps described herein, perform those steps and similar steps in different orders, and the like. It will also be appreciated that well-known features and techniques may be omitted for clarity.

Conventional techniques for packaging and encapsulating electronic devices include methods in which components are stacked on top of each or otherwise occupy multiple levels. However, such methods often involve bonding of one or more discrete monolithic devices or packaged devices on a substrate or directly on another monolithic device or packaged device, which can have disadvantages. As one example, the performance of radio-frequency (RF), microwave (MW) and millimeter-wave (mmWave) devices may be impaired when such devices and/or related components coupled to those devices are surrounded by dielectric materials such as polymer molding materials due to signal losses caused by attenuation of high frequency signals due to absorption within the dielectric(s).

Accordingly, benefits of embodiments herein can include enabling multilevel electronic device assemblies with gas-filled or evacuated cavities above sensitive components. Stacked assemblies according to one or more embodiments can have any suitable number of levels and devices on different levels can be isolated or interconnected as desired by way of interposer substrates which can include interconnections between layers and can also form part of metallic shield structures suitable for isolating selected layers or devices from electromagnetic interference.

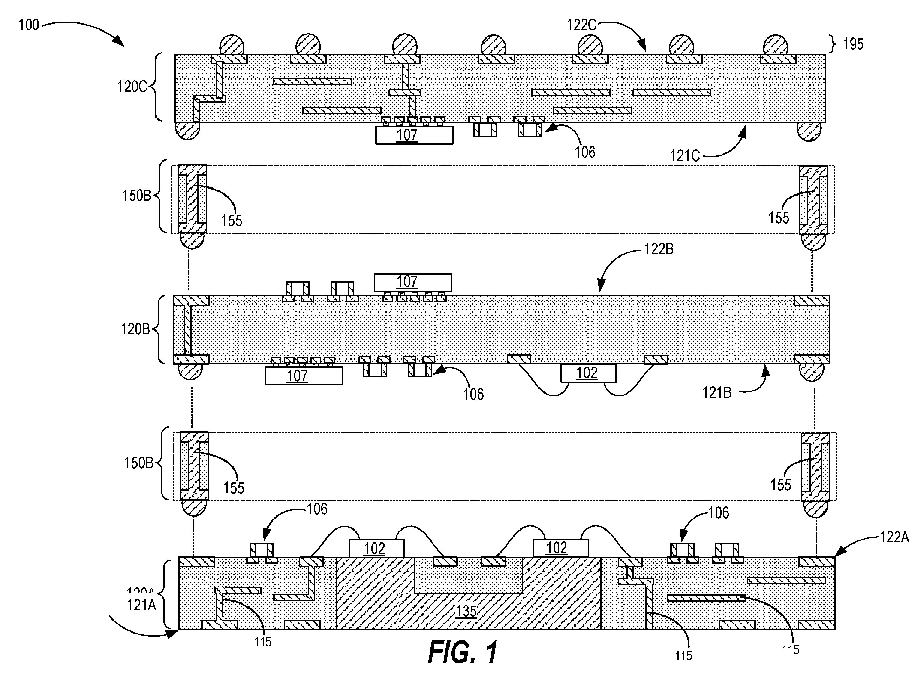

Along these lines, FIG. 1 is a partially exploded cross-sectional view of an example assembly 100 according to one or more embodiments. The assembly 100 is formed by three discrete circuit carrier substrates, which may also be referred to as circuit substrates and/or carriers (carriers 120; e.g., polymer-based printed circuit boards, ceramic-based circuit boards, and the like, as non-limiting examples, represented by the carrier 120A, the carrier 120B, and the carrier 120C). It will be appreciated that the assembly 100 is a non-limiting example and that embodiments herein can include any suitable number of carriers and fabricated from any suitable materials and including any number and type of suitable devices. Each carrier 120 has a bottom surface 121 (e.g., the bottom surfaces 121A, 121B, and 121C of the respective the carrier 120A, 120B, 120C) and a top surface 122 (e.g., the top surface 122A, 122B, and 122C of the respective the carrier 120A, 120B, 120C).

Each carrier 120 can include active and passive electronic devices on its bottom surface 121, its top surface 122, or both surfaces. Each carrier 120 can include electrically conductive interconnects 115 disposed within the carrier and on its top and bottom surfaces. As shown, interconnects 115 can include metalized pads on the bottom surface 121 and/or the top surface 122 of a carrier 120 and electronic devices (which can include active devices, passive devices, or both in any suitable arrangements) can be coupled to such pads using any suitable methods to interconnects 115. As examples, electronic devices 102 (e.g., semiconductor device die) are shown wire-bonded to interconnects 115 at the top surface 122A of the carrier 120A and to interconnects 115 at the bottom surface 121B of the carrier 120B. As further examples, passive components 106 (e.g., discrete resistors, capacitors, inductors, and the like) are shown with metallic contacts bonded to interconnects on the top surface 122A of the carrier 120A, the bottom surface 121B of the carrier 120B, and to the bottom surface 121C of the carrier 120C. As further examples, electronic devices 107 are depicted with metal pillars bonded to interconnects 115 on the top surface 122B of the carrier 120B and on the bottom surface 121C of the carrier 120C.

The carriers 120 are mechanically coupled to each other in a stacked arrangement by way of interposer substrates, or "interposers" (e.g., the interposer 150A and the interposer 150B). The interposer substrates 150 can include electrical interconnects 155 and are bonded or otherwise mechanically coupled between adjacent carriers 120. The interposers 150 can be bonded to the carriers 120 via solder bump bonding to contact pads (i.e., interconnects 115 at surfaces of the carriers 120), solder reflow, epoxy bonding, and/or any other suitable methods. In one or more embodiments, a first carrier such as one of the carriers 120 is also electrically coupled to one or more other such carriers in an assembly such as the assembly 100 via interconnects (e.g., an interconnect 155) within an interposer such as an interposer 150. In other words, an interconnect (e.g., an interconnect 115), electronic component (e.g., a component or electronic device 102, 106, or 107), or other feature on or within the first carrier is electrically coupled to one or more interconnects, electronic components, or other features on or within the other carrier(s).

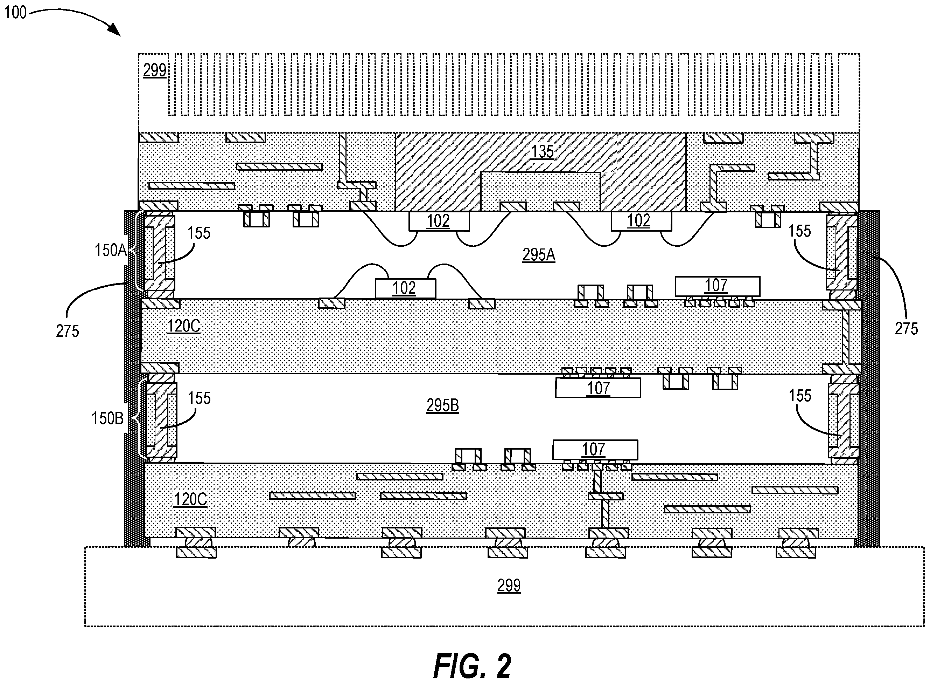

It will be appreciated that when two or more carriers (e.g., carriers 120) are mechanically coupled to each other via interposers (e.g., interposers 150), a cavity can be formed between the two carriers (e.g., between the carrier 120A and the carrier 120B or between the carrier 120B and the carrier 120C; see the cavity 295A and the cavity 295B in FIG. 2). In one or more embodiments, such a cavity is hollow or gas-filled (e.g., with air, or an inert gas). Such hollow or gas-filled cavities can be desirable for certain applications. For example, if radiofrequency (RF), microwave (MW), millimeter-wave (mmWave), or other high frequency electrical signals are propagated in the cavity or along a surface surrounded by the cavity (e.g., along a waveguide formed on a surface of a carrier 120), signal attenuation can be minimized compared with other packaging approaches in which spaces between adjacent stacked circuit layers are filled with polymer materials and the like. In addition, when compared to other approaches in which a single circuit substrate is sealed in a lidded package to create a hollow or gas-filled cavity, embodiments herein allow such cavities to be incorporated into high density packages with multiple circuit layers (e.g., multiple carriers 120). Furthermore, an assembly such as the assembly 100 may include multiple hollow or gas-filled cavities.

It will be understood that the assembly 100 as depicted in FIG. 1 and other assemblies depicted herein are for purposes of illustration and may show elements which are omitted in certain embodiments or show elements which are absent and that elements may be added or omitted purely to provide illustrative examples. Along these lines, in embodiments described herein, interconnects (e.g., interconnects 115 and interconnects 155) can be arranged in any suitable manner. For instance, as shown in FIG. 1, interconnects 115 can be routed on surfaces of carriers and within carriers in order connect electronic devices to other devices on the same surface or to devices or external contact pads on an opposite surface of the same carrier. Interconnects within interposers (e.g., interconnects 155 within interposers 150) can be used to form electrical connections between different carriers. For example, on the left side of FIG. 1, various interconnects 115 and interconnects 155 are coupled to each other such that there is a continuous electrically conductive path from the discrete carrier 120A to one of the solder bumps 195 on the top surface 122C of the carrier 120C. Alternatively, some connections between a carrier substrate and an interposer can serve as mechanical connections only.

As shown in FIG. 1, carriers can include additional structures such as heat sinks (e.g., thermally conductive heat sink 135 forming part of the carrier 120A, which may be referred to as a "coin"). The assembly 100 also includes a set of external contacts (depicted as solder bumps 195 on the top surface 122C of the carrier 120C. It will be appreciated that these features allow for the assembly 100 to be mounted to a circuit board or other substrate via the solder bumps 195 and also to be coupled to an additional heat sink assembly via the heat sink 135 in a so-called top-side cooling arrangement (as depicted in FIG. 2).

It will be appreciated that, the interposers 150 and similar interposers described herein may be described as monolithic substrates for purposes of illustration but that other arrangements are possible. Accordingly, in one or more embodiments, one or more interposers (e.g., one or more interposers 150) is formed from a monolithic substrate having features as described above in connection with FIG. 1 and/or in connection with other related interposers described herein. Meanwhile, in one or more embodiments one or more interposers are formed from individual segments which are not mechanically connected to each other or joined together by another material such as a polymer prior to being incorporated into an assembly such as the assembly 100. As one non-limiting example, an interposer such as an interposer 150 may include multiple discrete "bricks" which are bonded to a carrier such as a carrier 120 at different locations (e.g., around an outer perimeter of the carrier).

FIG. 2 is a cross-sectional view of the assembly 100 after the carriers 120 have been coupled to each other via the interposers 150. It will be understood that elements described in connection with FIG. 1 and similar elements may not be separately labeled or described in connection with FIG 2. As illustrated in FIG. 2, interposers (e.g., interposers 150) and carriers (e.g., discrete carriers 120) according to embodiments herein can be configured to such that one or more fully-enclosed cavities (e.g., the cavity 295A between the carrier 120A and the carrier 120B or the cavity 295B between the carrier 120B and the carrier 120C). As shown in FIG. 2, when the example assembly 100 is "flipped" relative to its orientation in FIG. 1, the example assembly 100 can be coupled to a larger circuit board or other substrate (e.g., the substrate 298) via the solder bumps 195 on the top surface 122C of the carrier 120C. Meanwhile, in the arrangement pictured in FIG. 2, the heat sink 135 can be coupled to an additional heat sink (e.g., the heat sink 299).

As shown in FIG. 2, in one or more embodiments, an assembly such as the assembly 100 has one or more external edges encapsulated within a polymeric material such as the molding material 275 shown. It will be understood that, in such embodiments, any suitable arrangement of such molding material may be used. For example, in one or more embodiments, molding material is present at edges of one or more interposers (e.g., one or more interposers 150) but not at edges of one or more other interposers. Similarly, in one or more embodiments, molding material is present at edges of one or more carriers (e.g., one or more interposers 120) but not at edges of one or more other carriers.

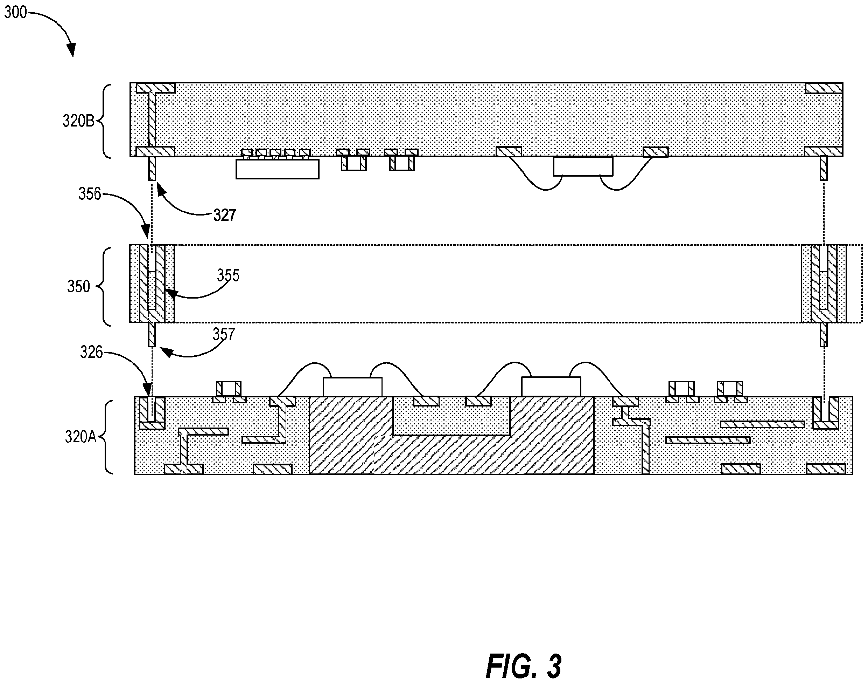

FIG. 3 is a partially exploded cross-section of another example assembly presented to illustrate embodiments in which carriers are joined to each other via interposers via a system of mating pins and sockets. It will be understood that elements described in connection with previous Figures and similar elements may not be separately labeled or described in connection with FIG 3. The assembly 300 includes a carrier 320A and a carrier 350B that are joined by an interposer 350. In this example, the carrier 320A includes a metalized socket 326 at the top surface 322A that extends into the carrier 320A. The socket 326 configured to receive a corresponding metalized pin. The interposer 350 includes an interconnect 355 (related to the interconnects 155 of the interposers 150) which is provided with a pin 357 on one surface that is configured to mate with a corresponding socket such as the socket 326 of the carrier 320A. The interconnect 355 also includes, on an opposite surface of the interposer 350, a metalized socket 356 configured to mate with a corresponding pin. In this example, the carrier 320B includes pins 327 (optionally coupled to interconnects 315 on and/or within the carrier 320B) on its bottom surface 321B which are configured to mate with the socket 356 of the interposer 350. It will be appreciated that in one or more embodiments, a socket such as a socket 326 or a socket 356 is configured as a mechanical connection point only while in one or more other embodiments, such a socket is configured to perform as both a mechanical connection point and an electrical connection point. In some embodiments, a pin and/or socket which does not make an electrical connection may not be metalized.

It will be appreciated that, in embodiments which include an interposer such as the interposer 350 or related interposers, pins and sockets may be arranged in any suitable manner. For instance, an interposer may have only sockets on both surfaces and the corresponding pins may be disposed on the carriers. Alternatively, a carrier (e.g., a carrier 320) and/or an interposer (e.g., the interposer 350) may have both sockets (e.g., a socket 326 or 356) and pins (e.g., pins 327 or 357) on one or both of top and bottom surfaces, distributed in any suitable arrangement.

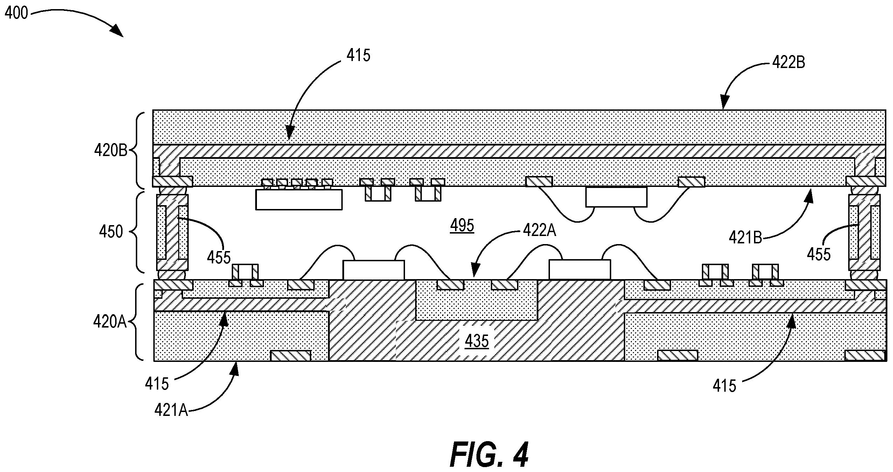

FIG. 4 is a cross-sectional view of another example assembly which illustrates features of one or more embodiments. It will be understood that elements described in connection with previous Figures may not be separately labeled or described in connection with FIG. 4. The assembly 400 includes a first carrier 420A that is mechanically and electrically coupled to a second carrier 420B via an interposer 450. Similarly to the carrier 120A of the example assembly 100, the carrier 420A includes a thermally conductive heat sink 432 (e.g., a "coin" or heat sink 135). The heat sink 435 is also electrically conductive (i.e., metallic) and coupled to interconnects 415 within the carrier 420A that span the width of the carrier 420A to either side of the heat sink 435. These interconnects 415 are in turn electrically coupled to one or interconnects 415 within the carrier 420B via the interconnects 455 of the interposer 450, and form a continuous conductive path that surrounds the cavity 495 formed between the carrier 420A and the carrier 420B. The interconnects 415 and the heat sink 435 can be extended through the thickness of the carriers 420A, 420B and the interposer 450 (i.e., along a direction perpendicular to the cross-sectional plane depicted in FIG. 4) to create a continuous electrically conductive enclosure which can shield components within the cavity 495 (and/or components within the carrier 420A, the carrier 420B, components on the top surface 422A of the carrier 420A and/or components on the bottom surface 421B of the carrier 420B) from electromagnetic interference. Similarly, devices external to the cavity 495 can be shielded from electromagnetic interference originating from devices within the cavity 495. It will be appreciated that an electromagnetically shielded cavity such as the cavity 495 can be formed between any two carriers in a stacked assembly of two or more carriers (e.g., carriers 120, 320, or 420).

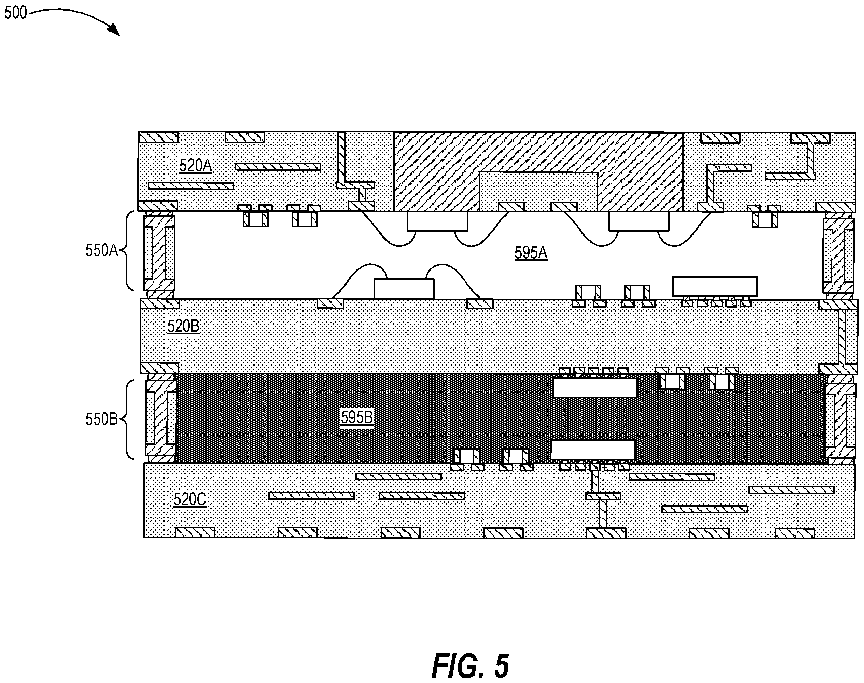

FIG. 5 is a cross-sectional view of another example assembly which illustrates features of one or more embodiments. It will be understood that elements described in connection with previous Figures and similar elements may not be separately labeled or described in connection with FIG. 5. The assembly 500 includes a first carrier 520A. a second carrier 520B, and a third carrier 520C. The carrier 520A is joined to the carrier 520B by an interposer 550A, forming a cavity 595A while the carrier 520B is joined to the carrier 520C by the interposer 550B, forming a cavity 595B. In one or more embodiments, as illustrated by the assembly 500, a cavity between two carriers (e.g., the cavity 595B as shown, a cavity such as the cavity 595A, or a similar cavity) is filled by volume of polymeric molding material. It will be understood that nothing herein is intended to require that a particular cavity between two carriers is filled by molding material or to require any particular number of cavities in an assembly of two more carriers be filled with molding material and that any number of cavities may be filled by molding material or unfilled according to embodiments herein.

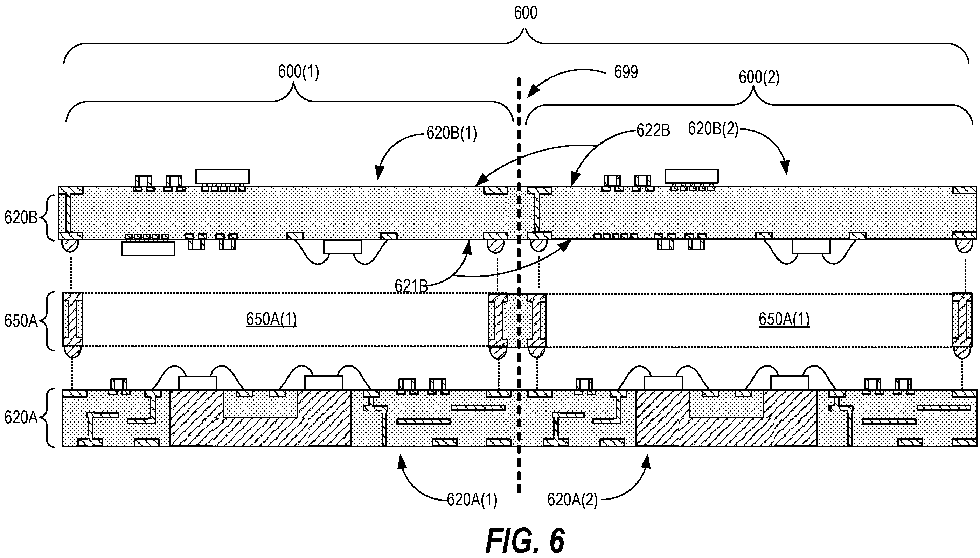

FIG. 6 is a partially cross-sectional view which illustrates features of one or more embodiments. It will be understood that elements described in connection with previous Figures and similar elements may not be separately labeled or described in connection with FIG. 6. As illustrated in FIG. 6, assemblies according to embodiments herein may be fabricated using known techniques for large scale manufacturing and assembly of devices that employ circuit carrier substrates related to the carriers described herein. Such techniques included so-called panel level manufacturing techniques in which numerous carriers are fabricated simultaneously as part of a larger "panel" substrate. After fabrication, a panel can be singulated into individual carriers, either before or after the carriers are populated with devices (e.g., via solder reflow or other suitable techniques).

As shown in FIG. 6, three panels can be assembled and then singulated to form two identical assemblies: an assembly 600(1) and an assembly 600(2). The panel 620A includes a carrier 620A(1) and a carrier 620A(2). The two carriers of the panel 620A are identical, but it will be understood that there is no requirement that all carriers (or other structures( forming part of a single panel are identical. Similarly, the panel 620B includes two identical carriers 620B(1) and 620B(2). The panels 620A and 620B can be joined as indicated by a panel 650A that includes two identical interposers 650A(1) and 650A(2) to form a panel assembly 600 that includes two identical assemblies 600(1) and 600(2). It will be understood that although the panel assembly 600 includes two panels, panel assemblies according to embodiments herein and assemblies according to embodiments herein can be formed using panels of any suitable size and arrangement of carriers and/or interposers.

In an example assembly process, each panel can be populated with devices prior to assembly of a panel assembly such as the panel assembly 600 as indicated. Panels can also be populated in any suitable order. For instance, the bottom surface 621 B of a panel such as the panel 620B can be populated, followed by populating the top surface of such a panel (e.g., the top surface 622B of the panel 620B) either before or after the panel is joined to another panel such as the panel 620A via an interposer panel such as the panel 650A.

It will be understood that the stacked carrier architectures described herein can have various advantages when combined with panel-level manufacturing approaches. As one example, panel level assemblies that include metallic shielding structures (e.g., as described in connection with the assembly 400 of FIG. 4) can be fabricated and assembled in large numbers, followed by singulation into individual assemblies that include both electromagnetic shielding and hollow cavities (e.g., the cavity 495), whereas such large scale assembly may not be economically attractive for metal packages that include metalized cavities and require bonding of a metallic lid to each cavity. Furthermore, devices that require such shielding and/or a hollow or air-filled cavity can be easily interconnected and stacked more readily than in conventional approaches in which devices are assembled into individual shielded and/or hollow packages.

### VARIOUS EXAMPLES

Features of embodiments may be understood by way of one or more of the following examples:
Example 1: a device or method that includes a first circuit substrate having a top surface and bottom surface; a second circuit substrate having a top surface and bottom surface; and a first interposer substrate disposed between the first circuit substrate and the second circuit substrate. The second circuit substrate is disposed above the first circuit substrate and the bottom surface of the second circuit substrate faces the top surface of the first circuit substrate. The first interposer substrate is disposed between the first circuit substrate and the second circuit substrate mechanically couples the first circuit substrate to the second circuit substrate. A first electronic component is mechanically bonded and electrically coupled to the top surface of the first circuit substrate or to the bottom surface of the second circuit substrate. The interposer substrate, the top surface of the first circuit substrate, and the bottom surface of the second circuit substrate jointly define a cavity between the first circuit substrate and the second circuit substrate.
Example 2: The device or method Example 1, where the first interposer substrate includes an electrical interconnect that electrically couples the first circuit substrate to the second circuit substrate.
Example 3: The device or method of Example 1 or Example 2 that also includes an electrically-conductive shield structure. The shield structure is configured to shield the first electronic component from electromagnetic interference or to shield components outside the electrically-conductive shield structure from electromagnetic interference generated within the shield structure. The shield structure is formed at least in part by a first portion disposed on or within the first circuit substrate and a second portion disposed on or within the second circuit substrate. The first portion of the shield structure is directly electrically coupled to the second portion of the shield structure by the electrical interconnect of the first interposer substrate.
Example 4: The device or method of any of Examples 1-3, that also includes a third circuit substrate having a top surface and bottom surface; and a second interposer substrate disposed between the second circuit substrate and the third circuit substrate. The third circuit substrate is disposed above the second circuit substrate and the bottom surface of the third circuit substrate faces the top surface of the second circuit substrate. The second interposer substrate disposed between the second circuit substrate and the third circuit substrate and mechanically couples the third circuit substrate to the second circuit substrate. The first interposer substrate includes and electrical interconnect that couples the first circuit substrate to the second circuit substrate. The second interposer substrate includes an electrical interconnect that couples the second circuit substrate to the third circuit substrate. The first circuit substrate is electrically coupled to the third circuit substrate via the electrical interconnects of the first interposer substrate and the second interposer substrate.
Example 5: The device or method of any of Examples 1-4 that also includes a thermally-conductive heat sink formed within the first circuit substrate that extends from the top surface of the first circuit substrate to the bottom surface of the first circuit substrate. The first electronic component disposed on the top surface of the first circuit substrate or a different electronic component disposed on the top surface of the first circuit substrate is directly thermally coupled to the heat sink at the top surface of the first circuit substrate.
Example 6: The device or method of any of Examples 1-5 that also includes a first set of electrical contacts that are disposed on a circuit substrate that is spaced apart from the first circuit substrate. The first set of electrical contacts includes electrical contacts that are coupled to one or more electronic components within the assembly.
Example 7: The device or method of any of Examples 1-6, where the first circuit substrate is coupled to the first interposer substrate via a metal pin that is mated with a corresponding socket. The metal pin protrudes from a surface of the first interposer substrate and the corresponding socket is a recessed socket formed in the first circuit substrate. The metal pin protrudes from a surface of the first circuit substrate and the corresponding socket is a recessed socket formed in the first interposer substrate.
Example 8: The device or method of any of Examples 1-7, where the first electronic component is mechanically bonded and electrically coupled to the top surface of the first circuit substrate; a second electronic component is mechanically bonded and electrically coupled to the bottom surface of the second circuit substrate.
Example 9: The device or method of any of Examples 1-8 where the cavity is filled with a volume of polymeric molding material.
Example 10: The device or method of any of Examples 1-9, where an outer edge of the device is encapsulated within a volume of polymeric molding material.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no Intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

**The** foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. An assembly comprising:
a first circuit substrate having a top surface and bottom surface;
a second circuit substrate having a top surface and bottom surface, wherein the second circuit substrate is disposed above the first circuit substrate and the bottom surface of the second circuit substrate faces the top surface of the first circuit substrate;
a first interposer substrate disposed between the first circuit substrate and the second circuit substrate that mechanically couples the first circuit substrate to the second circuit substrate;
wherein a first electronic component is mechanically bonded and electrically coupled to the top surface of the first circuit substrate or to the bottom surface of the second circuit substrate; and
wherein the first interposer substrate, the top surface of the first circuit substrate, and the bottom surface of the second circuit substrate jointly define a cavity between the first circuit substrate and the second circuit substrate.

2. The assembly of claim 1, wherein the first interposer substrate includes an electrical interconnect that electrically couples the first circuit substrate to the second circuit substrate.

3. The assembly of claim 2, further comprising:
an electrically-conductive shield structure configured to shield the first electronic component from electromagnetic interference or to shield components outside the electrically-conductive shield structure from electromagnetic interference generated within the shield structure;
wherein the shield structure is formed at least in part by a first portion disposed on or within the first circuit substrate and a second portion disposed on or within the second circuit substrate; and
wherein the first portion of the shield structure is directly electrically coupled to the second portion of the shield structure by the electrical interconnect of the first interposer substrate.

4. The assembly of any preceding claim, further comprising:
a third circuit substrate having a top surface and bottom surface, wherein the third circuit substrate is disposed above the second circuit substrate and the bottom surface of the third circuit substrate faces the top surface of the second circuit substrate; and
a second interposer substrate disposed between the second circuit substrate and the third circuit substrate that mechanically couples the third circuit substrate to the second circuit substrate;
wherein the first interposer substrate includes and electrical interconnect that couples the first circuit substrate to the second circuit substrate;
wherein the second interposer substrate includes an electrical interconnect that couples the second circuit substrate to the third circuit substrate; and
wherein the first circuit substrate is electrically coupled to the third circuit substrate via the electrical interconnects of the first interposer substrate and the second interposer substrate.

5. The assembly of any preceding claim, further comprising:
a thermally-conductive heat sink formed within the first circuit substrate that extends from the top surface of the first circuit substrate to the bottom surface of the first circuit substrate;
wherein the first electronic component disposed on the top surface of the first circuit substrate or a different electronic component disposed on the top surface of the first circuit substrate is directly thermally coupled to the heat sink at the top surface of the first circuit substrate.

6. The assembly of claim 5, further comprising:
a first set of electrical contacts that are disposed on a circuit substrate that is spaced apart from the first circuit substrate;
wherein the first set of electrical contacts includes electrical contacts that are coupled to one or more electronic components within the assembly.

7. The assembly of any preceding claim,
wherein the first circuit substrate is coupled to the first interposer substrate via a metal pin that is mated with a corresponding socket;
wherein the metal pin protrudes from a surface of the first interposer substrate and the corresponding socket is a recessed socket formed in the first circuit substrate; or
wherein the metal pin protrudes from a surface of the first circuit substrate and the corresponding socket is a recessed socket formed in the first interposer substrate.

8. The assembly of any preceding claim,
wherein the first electronic component is mechanically bonded and electrically coupled to the top surface of the first circuit substrate;
and wherein a second electronic component is mechanically bonded and electrically coupled to the bottom surface of the second circuit substrate.

9. The assembly of any preceding claim, wherein the cavity is filled with a volume of polymeric molding material.

10. The assembly of any preceding claim, wherein an outer edge of the assembly is encapsulated within a volume of polymeric molding material.

11. A method of forming an assembly, the method comprising:
receiving a first circuit substrate having a top surface and bottom surface;
reeving a second circuit substrate having a top surface and bottom surface; and
coupling the first circuit substrate to the second circuit substrate by coupling a first interposer substrate between the first circuit substrate and the second circuit substrate that mechanically couples the first circuit substrate to the second circuit substrate;
wherein the second circuit substrate is disposed above the first circuit substrate and bonding the second circuit substrate and the bottom surface of the second circuit substrate faces the top surface of the first circuit substrate;
wherein a first electronic component is mechanically bonded and electrically coupled to the top surface of the first circuit substrate or to the bottom surface of the second circuit substrate; and
wherein the first interposer substrate, the top surface of the first circuit substrate, and the bottom surface of the second circuit substrate jointly define a cavity between the first circuit substrate and the second circuit substrate.

12. The method of claim 11, wherein the first interposer substrate includes an electrical interconnect that electrically couples the first circuit substrate to the second circuit substrate.

13. The method of claim 12, further comprising:
forming an electrically-conductive shield structure configured to shield the first electronic component from electromagnetic interference or to shield components outside the electrically-conductive shield structure from electromagnetic interference generated within the shield structure;
wherein the shield structure is formed at least in part by a first portion disposed on or within the first circuit substrate and a second portion disposed on or within the second circuit substrate; and
wherein the first portion of the shield structure is directly electrically coupled to the second portion of the shield structure by the electrical interconnect of the first interposer substrate.

14. The method of claim 11, further comprising:
disposing a third circuit substrate above the second circuit substrate, the third circuit substrate having a top surface and bottom surface, wherein the bottom surface of the third circuit substrate faces the top surface of the second circuit substrate; and
disposing a second interposer substrate between the second circuit substrate and the third circuit substrate that mechanically couples the third circuit substrate to the second circuit substrate;
wherein the first interposer substrate includes and electrical interconnect that couples the first circuit substrate to the second circuit substrate;
wherein the second interposer substrate includes an electrical interconnect that couples the second circuit substrate to the third circuit substrate; and
wherein the first circuit substrate is electrically coupled to the third circuit substrate via the electrical interconnects of the first interposer substrate and the second interposer substrate.

15. The method of claim 11,
wherein the first circuit substrate includes a thermally-conductive heat sink formed within the first circuit substrate that extends from the top surface of the first circuit substrate to the bottom surface of the first circuit substrate; and
wherein the first electronic component disposed on the top surface of the first circuit substrate or a different electronic component disposed on the top surface of the first circuit substrate is directly thermally coupled to the heat sink at the top surface of the first circuit substrate.
